# EUROPEAN PATENT APPLICATION

(11) **EP 3 024 020 A1**
(43) Date of publication of application: **25.05.2016**
(21) Application number: 14193822.5
(22) Date of filing: 19.11.2014
(51) Int. Cl.: H01L 21/762

(54) **Semiconductor device and method**

(71) Applicant: NXP B.V., 5656 AG Eindhoven (NL)
(72) Inventor: Magnee, Petrus Hubertus Cornelis, Redhill, Surrey RH1 1SH (GB); Peters, Wilhelmus Cornelis Maria, Redhill, Surrey RH1 1SH (GB)
(74) Representative: Crawford, Andrew

(57) **Abstract**

A semiconductor device and a method of making the same. The device includes a semiconductor substrate including a body region having a first conductivity type. The device also includes an array of interconnected trenches extending into the body region from a surface of the substrate. The device further includes a plurality of channel stoppers. Each channel stopper includes a doped region of the first conductivity type located at a side of one or more of the trenches at a position intermediate a top of the trench and a bottom of the trench.

## Description

### FIELD OF THE INVENTION

This invention relates to a semiconductor device and to a method of making a semiconductor device.

### BACKGROUND OF THE INVENTION

Deep trench isolation (DTI) is often used to isolate features of a semiconductor device from the underlying substrate or from other features of the device that are also located on the substrate. For instance, it is common to use an array of trenches to separate and isolate neighbouring active devices located on the substrate (e.g. transistors) from each other. This kind of isolation can be implemented by positioning one or more rings of DTI around each active device. In another example, DTI may be used to increase the level of isolation for passive components (e.g. inductors, capacitors or conductive tracks) from the underlying substrate. For instance, a grid of DTI can be located beneath the passive component(s), whereby capacitance between the passive component and the substrate is reduced..

DTI trenches may ideally be completely filled with a dielectric such as silicon dioxide (SiO₂). However, because the thermal expansion coefficient of silicon dioxide is different to that of silicon, an array of DTI trenches completely filled with silicon dioxide may suffer from stresses generated during annealing steps associated with front end processing. This may cause the formation of defects within the substrate, in the vicinity of the trenches.

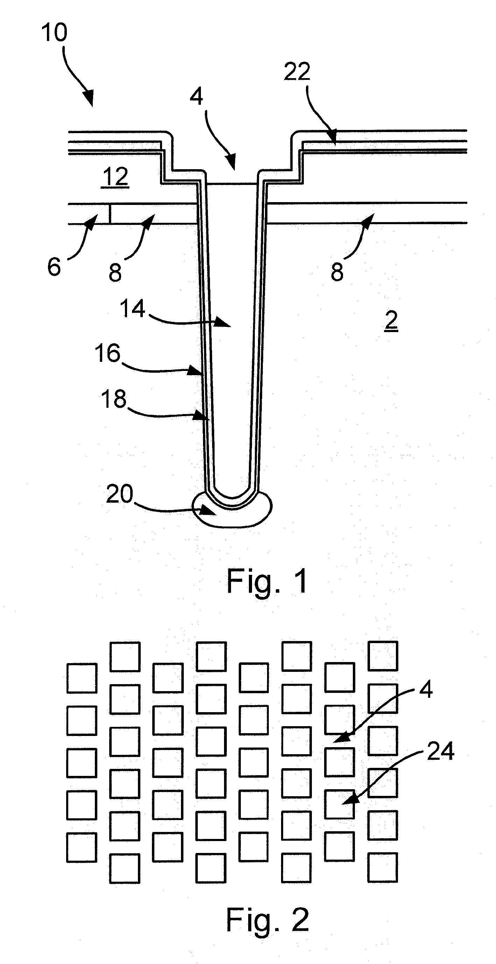

A known solution to this problem is to line the trenches with silicon dioxide and/or another dielectric and to fill the remaining portions of the trench with a material having a thermal expansion coefficient that is similar to that of silicon. A common choice of material for filling trenches that have been lined this way is polysilicon. An example of this is shown in Figure 1.

Figure 1 shows a semiconductor device 10 having an array of interconnected trenches 4 that extend into a body region 2 of a semiconductor substrate. The body region 2 is lightly doped (p-type, in this example). As mentioned above, the trench 4 is lined with a layer of thermal oxide 16 and a deposited layer of SiO₂ (e.g. TEOS). The trench 4 is then filled with polysilicon 14.

Because the polysilicon 14 in the trenches 4 is left floating, the combination of the polysilicon 14 and the silicon dioxide liner 16 can act as a gate of a parasitic MOSFET within the device 10. This is especially the case where, as shown in Figure 1, the DTI is used to separate two bipolar transistors in a BiCMOS device.

In Figure 1, the regions 6 and 8 are parts of neighbouring bipolar transistors. In particular, the region 6 is a buried p-type region, while the regions 8 are buried n-type regions. The regions 8 may, for example, be the collectors of the bipolar transistors that are isolated from each other by the trench 4. The above-mentioned parasitic MOSFET may be formed by the regions 8 on either side of the trench 4 acting as the source and drain, while the polysilicon 14 acts as a gate electrode, the silicon dioxide liner 16 in the trench 4 acting as a gate oxide. In accordance with the parasitic MOSFET, a potential applied by the floating polysilicon 14 in the trench 4 may generate an inversion layer around the sides and bottom of the trench, allowing charge carriers to flow between the "source" and "drain" of the parasitic MOSFET, namely the regions 8.

In order to prevent the formation of a parasitic MOSFET in this way, it is known to provide a channel stopper 20 at the bottom of the trench 4. The channel stopper 20 is typically a doped region located beneath the trench 4 that has a conductivity type that is the same conductivity type as the body region 2, but which is normally more highly doped than the body region 2. The highly doped channel stopper 20 acts to prevent the formation of an inversion layer in the region beneath the trench 4, thereby cutting off any flow of charge carriers between the "source" and "drain" of the parasitic MOSFET, around the edge of the trench 4.

As noted above, DTI trenches are often provided in the form of an interconnected array. Figure 2 shows the layout of such an array when viewed from above the substrate. As can be seen in Figure 2, the trenches 4 are laid out in a mesh, whereby the channel stoppers 20 at the bottoms of the trenches 4 are also interconnected. In some examples, Shallow Trench Isolation (STI) 24 may be provided in the spaces between the trenches 4.

Because the trenches 4 shown in Figure 2 are provided in an interconnected array, the interconnected arrangement of the channel stoppers 20 at the bottoms of the trenches 4 introduces a further problem. In particular, the highly doped regions forming the channel stoppers 20 form an electrically conductive mesh located at the bottom of the array. This electrically conductive mesh results in poor lateral electrical isolation within the device 10.

### SUMMARY OF THE INVENTION

Aspects of the invention are set out in the accompanying independent and dependent claims. Combinations of features from the dependent claims may be combined with features of the independent claims as appropriate and not merely as explicitly set out in the claims.

According to an aspect of the invention, there is provided a semiconductor device. The device includes a semiconductor substrate including a body region having a first conductivity type. The device also includes an array of interconnected trenches extending into the body region from a surface of the substrate. The device further includes a plurality of channel stoppers. Each channel stopper includes a doped region of the first conductivity type located at a side of one or more of the trenches at a position intermediate a top of the trench and a bottom of the trench.

According to another aspect of the invention, there is provided a method of making a semiconductor device. The method includes providing a semiconductor substrate including a body region having a first conductivity type. The method also includes etching, to a first depth, an array of interconnected trenches extending into the body region from a surface of the substrate. The method further includes implanting doped regions of the first conductivity type at a bottom of at least some of the trenches at said first depth. The method also includes annealing the substrate to allow the doped regions to diffuse laterally outward from the bottoms of the trenches. The method also includes further etching the array of interconnected trenches to a second depth. The outdiffused doped regions form channel stoppers.

In accordance with embodiments of this invention, an array of interconnected trenches may be provided with channel stoppers in a manner that avoids the formation of a conductive channel at the bottom of the array. Because the channel stoppers are located intermediate the tops and bottoms of the trenches, lateral conduction of charge carriers is blocked by the intervening trenches. Accordingly, embodiments of this invention may reduce capacitance between features of the device that may be located top of the array (e.g. passive components) and the underlying substrate, while also providing good lateral isolation (for instance for active components such as transistors that are separated from each other by the array).

The above mentioned features of the device may, for example, be one or more passive components such as inductors, capacitors or electrically conductive interconnections.

In one embodiment, the channel stoppers may form a plurality of isolated islands, when viewed from above the surface of the substrate. The edges of the islands may defined by the sides of the trenches. Because the islands are electrically isolated from each other, lateral conduction of charge carriers between the islands is inhibited.

The isolated islands may comprise closed loops, when viewed from above the surface of the substrate. The sides of the loops may be formed by the doped regions located at the sides of neighbouring trenches.

The array of interconnected trenches may form a pattern such as a mesh or grid, when viewed from above the surface of the substrate. The pattern may be repeating pattern. A repeat distance of the pattern may be chosen according to the degree of isolation required. In one example, a lateral width of the trenches may be in the range 0.5-1.5µm, and the spacing of the trenches may be in the range 2-10µm.

At least some of the interconnected trenches may extend through a semiconductor region having a second conductivity type located above the body region having the first conductivity type. The channel stopper may act to prevent the activation of a parasitic MOSFET in which the semiconductor region having the second conductivity type form the source and drain and in which the body region forms the channel.

The trenches may have a depth in the range 10µm ≤ dₜ ≤ 30µm, for good capacitive isolation from the underlying substrate.

In some examples, the channel stoppers may be provided approximately half way between the top and bottom of the trenches. The channel stoppers may be located at a depth (dt - 5µm) ≤ d_{cs} ≤ (dₜ - 1µm) measured from the surface of the substrate, wherein dt is the depth of the trench.

The dopant used to dope the doped region may be Boron (where the first conductivity type is p-type) or Arsenic, Phosphorus or Antimony (where the first conductivity type is n-type).

The doping concentration of the doped region may be higher than the doping concentration of the body region, to ensure that no parasitic MOSFET can be activated by inhibiting the formation of an inversion layer. In one embodiment, the doping concentration of the doped region is at least one order of magnitude higher than the doping concentration of the body region. In one embodiment, the doping concentration of the doped region is in the range 1x10¹⁵ cm⁻³ ≤ n ≤ 1x10¹⁷ cm⁻³.

At least some of the trenches may pass completely through the body region into an underlying region of the substrate.

The trenches may be lined with dielectric. The lined trenches may by filled with a material such as polysilicon.

### BRIEF DESCRIPTION OF THE DRAWINGS

Embodiments of the present invention will be described hereinafter, by way of example only, with reference to the accompanying drawings in which like reference signs relate to like elements and in which:
Figure 1 shows a cross-section of an isolation trench;
Figure 2 shows a top view of an arrangement of isolation trenches;
Figure 3 shows an isolation trench in accordance with an embodiment of the invention;
Figure 4 shows a top view of an arrangement of isolation trenches in accordance with an embodiment of the invention; and
Figure 5 illustrates a method of making an isolation trench in accordance with an embodiment of the invention.

### DETAILED DESCRIPTION

Embodiments of the present invention are described in the following with reference to the accompanying drawings.

Embodiments of this invention can provide a semiconductor device including an array of interconnected trenches that extend from a surface of a semiconductor substrate into a body region of the substrate. The substrate has a first conductivity type, which may be either p-type or n-type. The array of interconnected trenches may, for example, be isolation trenches that allow features of the semiconductor device to be isolated from the underlying substrate. For instance, the trenches may reduce capacitance between features of the device that can be provided above the array of trenches and the underlying substrate. Such features may include active components such as transistors. For instance, an array of trenches of the kind described herein can be used to reduce capacitance between the collector of one or more bipolar transistors and the underlying substrate. In other examples, features of the device such as passive components (e.g. inductors, capacitors and/or conductive tracks on the substrate) may be capacitively isolated from the underlying substrate.

According to embodiments of the invention, the semiconductor device also includes a plurality of channel stoppers. As described herein, channel stoppers are features that can prevent the formation of a parasitic MOSFET within the device. The channel stopper can include a doped region having the same conductivity type as the body region of the substrate into which the array of interconnected trenches extends. The doped region of the channel stopper can prevent or inhibit the formation of an inversion layer in the vicinity of the trenches, for instance around at least a part of the edges of the trenches. In some examples, the doped regions may be more highly doped than the body region, to enhance the ability of the channel stoppers to inhibit the formation of an inversion layer.

As will be described in more detail below, the doped region of each channel stopper is located at a side of one or more of the trenches of the array, at a position intermediate a top of the trench and a bottom of the trench. The location of the doped regions of the channel stoppers can prevent the channel stoppers from forming an interconnected conductive array beneath the trenches. Because of this, in addition to reducing capacitance between features of the device provided above the array and the underlying substrate, a device according to embodiments of this invention can include an array of trenches providing good lateral electrical isolation.

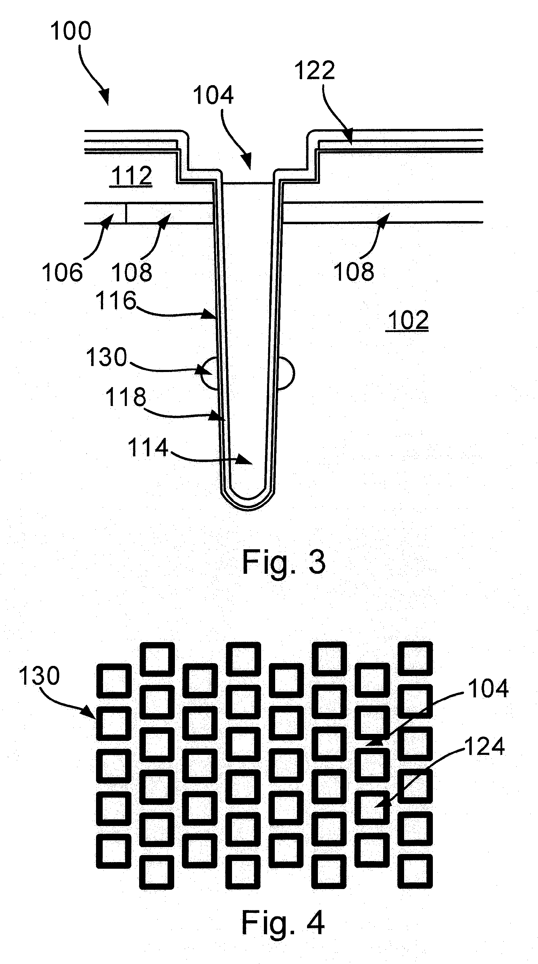

A first embodiment of a semiconductor device 100 according to an embodiment of this invention is shown in Figures 3 and 4. In this embodiment, the semiconductor device 100 includes trenches 104 that extend into the body region 102 of a semiconductor substrate, from a surface of the substrate (e.g. an upper surface of the body region 102). Figure 4 shows the layout of the trenches 104 viewed from above the substrate, while Figure 3 shows a cross section side view of one of the trenches 104.

In addition to extending down into the body region 102, the trenches 104 may also extend through other features of the device 100, which may be provided on the surface of the substrate. For instance, the trenches 104 may extend through doped regions 106, 108 which, in this embodiment, are doped regions of active devices such as bipolar transistors that are provided on the surface of the body region 102. In particular, in the present embodiment, the regions 108 correspond to the collectors of bipolar transistors provided above the array of trenches. The regions 108 have a conductivity type that is different to the conductivity type of the body region 102. As will be described in more detail below, the provision of channel stoppers in accordance with embodiments of this invention can prevent the regions 108 from forming the source and drain of a parasitic MOSFET.

The device may also include further features located above the array of trenches, such as one or more epitaxially grown doped layers 112, silicon nitride (Si₃N₄) layers 122 and so forth. These further features may for instance form additional parts of the active components mentioned above. As noted above, it is envisaged that in addition to, or indeed instead of active components such as bipolar transistors, there may be provided passive components such as inductors, capacitors and/or electrically conductive tracks extending above the array of trenches. Such components may be formed in, for instance, a metallisation stack located above the array of trenches 104.

In this embodiment, the trenches 104 are provided with a liner 116, which comprises a dielectric, which may be thermally grown oxide. The dielectric may, for example, comprise silicon dioxide (SiO₂). Further dielectric layers 118 may also be provided (e.g. deposited in the trench 104).

In this embodiment, the trenches 104 are filled with a material 114. The material 114 may be chosen to have a thermal expansion coefficient that is similar to that of the body region 102 of the substrate so that during any annealing steps used to manufacture the device, the amount of stress generated due to differing amounts of expansion is limited. By way of example only, the material 114 may comprise polysilicon. The material 114 may be electrically conductive (again, e.g. polysilicon). If the material 114 is electrically conductive it may, as described above, contribute to the formation of a parasitic MOSFET in the device 100 by acting as the gate electrode of the parasitic MOSFET.

In this embodiment, the device includes channel stoppers 130. The channels stoppers 130 comprise doped regions. These doped regions have the same conductivity type as that of the body region 102 of the substrate (e.g. n-type or p-type). The doped regions of the channel stoppers 130 are located at a side of one or more of the trenches 104 of the device. In particular, and as shown in the example of Figure 3, the doped regions of the channel stoppers 130 are located at a position intermediate a top of the trenches 104 and a bottom of the trenches 104. As noted above, because the channel stoppers 130 are located at a position intermediate a top and a bottom of the trenches 104, they do not form a conductive array at the bottoms of the trenches 104. This is in contrast to devices such as those described above in relation to Figures 1 and 2. Accordingly, the array of interconnected trenches 104 provided in accordance with an embodiment of this invention can provide good lateral electrical isolation within the device 100.

The depths of the trenches 104 can be chosen in order to provide good capacitive isolation between the underlying substrate and any features provided above the array. In one embodiment, the depth dt of the trenches is in the range 10-3µm, measured from an upper surface of the body region 102. The channel stoppers 130 are, as noted above, located intermediate the tops and bottoms of the trenches 104. It is envisaged that the channel stoppers may be located as deep as possible while leaving at least a certain amount of the trench extending beneath the channel stoppers, so as to provide good separation between the channel stoppers 130 and the bottoms of the trenches for ensuring that a conductive mesh does not form, and to ensure that the channel stoppers are deep enough not to cause extra parasitic capacitance with features located above it (e.g. the doped region 108). In particular, in one embodiment, the channel stoppers are located at a depth (dt - 5µm)≤ d_{cs} ≤ (dₜ - 1µm) from the surface of the substrate (e.g. from the upper surface of the body region 102).

The dopants used to form the doped regions of the channel stoppers 130 can be selected according to the composition of the body region 102. By way of example only, where the body region 102 comprises p-type doped silicon, then the dopant used to form the channel stoppers 130 may be Boron. Where the body region 102 is n-type doped, the dopant used to form the channel stoppers 130 may comprise, for example, As, P or Sb.

In order to provide good protection against the formation of a parasitic MOSFET, the doped regions forming the channel stoppers 130 may be more highly doped than the body region 102 of the substrate. In accordance with an embodiment of the invention, it is envisaged that the doping concentration of the doped region may be in the range 1x10¹⁵cm⁻³ ≤ n ≤ 1x10¹⁷cm⁻³.

In some embodiments, the trenches 104 may pass completely through the body region 102 into the underlying substrate, which may have a different conductivity type to the body region 102. In such examples, the amount of lateral isolation provided by the array of trenches 104 would be substantially increased.

As noted herein, it is envisaged that the trenches 104 according to embodiments of this invention would be provided in an interconnected array. By way of example only, the interconnected array may take the form of a mesh or grid. The array may, for example, be a square array or a hexagonal array.

In the example of Figure 4 the trenches 104 are provided in the form of a mesh, the layout of which can be seen in Figure 4, which is a top view from above the substrate. When viewed from above the substrate, the doped regions of the channel stoppers 130 may form a plurality of isolated islands. From Figure 4 it can also be seen that each island may generally be isolated from neighbouring islands by intervening trenches 104. Because each island is isolated from its neighbouring islands by the intervening trenches, lateral conduction of charge carriers between the islands is inhibited. In some examples, Shallow Trench Isolation (STI) 124 may be provided in the spaces between the trenches 104.

The shape and configuration of the islands may take various forms. For instance, as can be seen from Figure 4, the islands may comprise closed loops formed collectively from the doped regions of channel stoppers 130 located at the sides of a plurality of neighbouring trenches 104. If the lateral extent of the channel stoppers 130 is sufficiently wide, the islands may completely fill the areas between the neighbouring trenches 104 at the depth of the channel stoppers 130. The islands may, for example, be square, rectangular, triangular or hexagonal, depending upon the layout of the trenches 104.

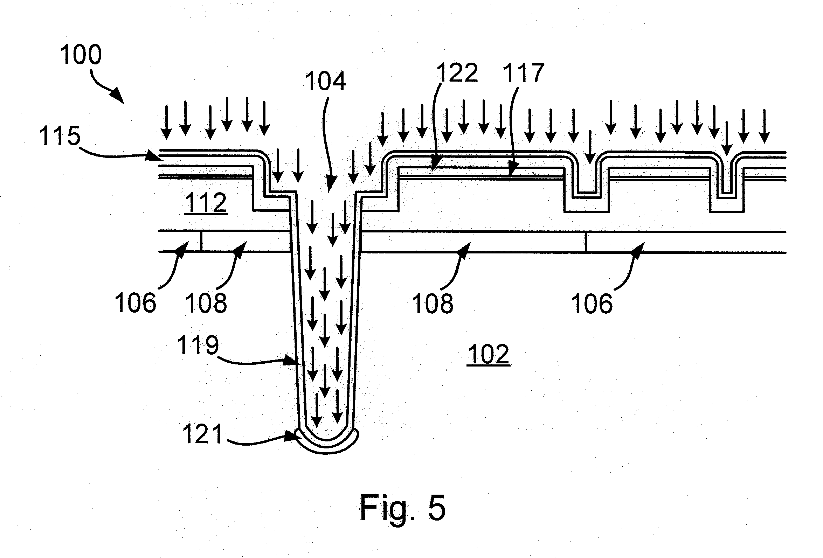

A method of making a semiconductor device according to an embodiment of this invention will now be described in relation to Figure 5.

In order to make the semiconductor device, there can first be provided a semiconductor substrate comprising a body region 102 having a first conductivity type (n-type or p-type) as described above. Optionally, features such as doped regions 106, 108 and/or epitaxial layers 112 and further layers such as pad oxide 117 (SiO₂) or silicon nitride layers 122 (Si₃N₄) may be provided. In the present example, these optional layers form parts of active components located above the body region 102. However, as noted above, it is envisaged that instead of (or as well as) the active devices, passive devices such as inductors, capacitors or conductive tracks may be located above the body region 102.

Having provided a semiconductor substrate having a body region 102 as noted above, in a next step, an array of interconnected trenches 104 can be etched into the body region 102, initially to a first depth. The initially etched array of interconnected trenches extend into the body region 102 from a surface of the substrate (e.g. from an upper surface of the body region 102) - however, at this stage the depth of the trenches 104 is shallower than the desired final depth. In particular, the depth of the initial etch may correspond approximately to the desired depth of the channel stoppers. In one embodiment, the initially etched depth of the trenches 104 at this stage may be in the range 5-29 µm.

As is well known in the art, appropriate masking can be used in accordance with the desired layout of the trenches 104 when viewed from above the substrate (e.g. for forming an array having a mesh- or grid-type in a square, hexagonal or triangular formation etc.). In the present embodiment, a hard mask 115 comprising a thick layer of TEOS is used to define the trench layout during etching.

In a next step, a screen oxide 119 (for example, TEOS) may be deposited over the surface of the substrate and into the trenches 104. After the screen oxide 119 has been deposited, ion implantation (represented by the arrows in Figure 5) can be used to form a doped region 121 at the bottoms of the partially etched trenches 104. The ions implanted at this stage can correspond to the dopants discussed above (e.g. Boron etc.) for forming the doped regions of the channel stoppers of the finished device.

The dosage of the implantation can be selected in accordance with the desired dopant concentration of the finished device. It is envisaged that the implant dosage may be in the range 1x10¹³ cm⁻² - 1x10¹⁴ cm⁻², to achieve a doping concentration in the finished device of approximately 1x10¹⁵ cm⁻³ - 1x10¹⁷ cm⁻³. In the present example, Boron ions are implanted at a dosage of 3x10¹³ cm⁻². Also, the energy of the implantation can be chosen in accordance with the desired penetration level of the dopants into the bottoms of the trenches 104. In the present example, the angle of implantation is 0° so that the ions can reach the bottoms of the trenches 104. Note that the screen oxide 119 may prevent penetration of the dopants through the sides of the trenches 104, while allowing the dopants to penetrate through the bottoms of the trenches to form the doped region 121.

In a next step, the substrate may be heated using, for example, a furnace annealing step. This may cause the dopants in the doped region 121 to diffuse laterally outwards to a certain extent. The amount of thermal energy applied to the substrate during the heating step can be chosen in accordance with the type of dopant used and the desired lateral spatial extent of the dopants for forming the channel stoppers in the finished device.

In a next step, the screen oxide 119 can be removed at least from the bottoms of the partially etched trenches 104, although it is envisaged also that all of the screen oxide 119 in the trenches may be removed. A further etching step can then be used to etch through the outdiffused doped region 121 and further down into the body region 102 of the substrate. The final depth of the array of trenches 104 can, as noted above, be in the range 10-30 µm.

After the array of trenches 104 has been etched to its final depth, further wet etching steps may be used to remove any remaining screen oxide 119 and any remaining parts of the hard mask 115 which was used to pattern the trenches during the etching.

After these layers have been removed, the trench may be lined with silicon dioxide 116 (which may be thermally grown) and/or any further layers 118 (which may be deposited) as described above in relation to Figure 3 and the trenches 104 may be filled with a material 114 such as polysilicon. This may thus result in an array of trenches 104 of the kind described above in relation to Figures 3 and 4.

Accordingly, there has been described a semiconductor device and a method of making the same. The device includes a semiconductor substrate including a body region having a first conductivity type. The device also includes an array of interconnected trenches extending into the body region from a surface of the substrate. The device further includes a plurality of channel stoppers. Each channel stopper includes a doped region of the first conductivity type located at a side of one or more of the trenches at a position intermediate a top of the trench and a bottom of the trench.

Although particular embodiments of the invention have been described, it will be appreciated that many modifications/additions and/or substitutions may be made within the scope of the claimed invention.

## Claims

1. A semiconductor device comprising:
a semiconductor substrate comprising a body region having a first conductivity type;
an array of interconnected trenches extending into the body region from a surface of the substrate; and
a plurality of channel stoppers, each channel stopper comprising a doped region of the first conductivity type located at a side of one or more of the trenches at a position intermediate a top of the trench and a bottom of the trench.

2. The semiconductor device of any preceding claim, wherein the channel stoppers form a plurality of isolated islands, when viewed from above the surface of the substrate.

3. The semiconductor device of claim 2, wherein the isolated islands comprise closed loops, when viewed from above the surface of the substrate.

4. The semiconductor device of claim 2 or claim 3, wherein each island is isolated from a neighbouring island by an intervening trench.

5. The semiconductor device of any preceding claim, wherein the array of interconnected trenches form a mesh or grid, when viewed from above the surface of the substrate.

6. The semiconductor device of any preceding claim, wherein at least some of the interconnected trenches extend through a semiconductor region having a second conductivity type located above said body region having the first conductivity type.

7. The semiconductor device of any preceding claim, wherein the trenches have a depth in the range 10µm ≤ dt ≤ 30µm.

8. The semiconductor device of claim 7, wherein the channel stopper is located at a depth (dt - 5µm) ≤ d_{cs} ≤ (dt - 1µm) measured from the surface of the substrate, wherein dₜ is the depth of the trench.

9. The semiconductor device of any preceding claim, wherein the doped region is doped with Boron (B), Arsenic (As), Phosphorus (P) or Antimony (Sb).

10. The semiconductor device of any preceding claim, wherein the doping concentration of the doped region is higher than the doping concentration of the body region.

11. The semiconductor device of claim 10, wherein the doping concentration of the doped region is in the range 1x10¹⁵cm⁻³ ≤ n ≤ 1x10¹⁷cm⁻³.

12. The semiconductor device of any preceding claim, wherein at least some of the trenches pass completely through the body region into an underlying region of the substrate.

13. The semiconductor device of any preceding claim, wherein the trenches are lined with dielectric.

14. The semiconductor device of any preceding claim, comprising at least one passive component located above the body region, wherein the array of interconnected trenches reduces capacitance between the at least one passive component and the substrate.

15. A method of making a semiconductor device, the method comprising:
providing a semiconductor substrate comprising a body region having a first conductivity type;
etching, to a first depth, an array of interconnected trenches extending into the body region from a surface of the substrate;
implanting doped regions of the first conductivity type at a bottom of at least some of the trenches at said first depth;
annealing the substrate to allow the doped regions to diffuse laterally outward from the bottoms of the trenches; and
further etching the array of interconnected trenches to a second depth,
wherein the outdiffused doped regions form channel stoppers.
